Europäisches Patentamt

European Patent Office

Office européen des brevets

(11) Publication number: **0 506 225 A2**

# EUROPEAN PATENT APPLICATION

(21) Application number: **92301132.4**

(22) Date of filing: **11.02.92**

(51) Int. Cl.⁵: **H01L 23/538**, H01L 25/065

(30) Priority: **26.03.91 US 675583**
**26.03.91 US 675243**

(43) Date of publication of application:
**30.09.92 Bulletin 92/40**

(84) Designated Contracting States:
**DE FR GB**

(71) Applicant: **International Business Machines Corporation**
**Old Orchard Road**
**Armonk, N.Y. 10504(US)**

(72) Inventor: **Gillett, John Brian**
**7 Meher Circle**
**Woodstock, New York 12498(US)**

(74) Representative: **Mitchell, Allan Edmund et al**
**IBM United Kingdom Limited Intellectual Property Department Hursley Park**
**Winchester Hampshire SO21 2JN(GB)**

(54) **Integrated circuit chip package.**

(57) An integrated circuit chip package comprises a first ceramic substrate 1 having integrated circuit chips 2 thereon and a second printed circuit card substrate 7 electrically connected to the substrate 1 and having signal input/output connections 3 for the chips 2 located at edges thereof. Conductive power planes 5 are separated from the signal input/output connections 3 and removably connected to the substrate 7 by an area array power connector 4. Power is provided from a power source 21 to the power planes 5 and thence through flexible signal connectors 13 to the connections 3.

FIG.4

The present invention relates to integrated circuit chip packages.

With the advent of relatively large, high performance integrated circuit systems, continuing efforts are underway to optimise the packaging topology in order to reduce package-caused delays and skews to a minimum. Moreover, the ever increasing desire and demands for speed and integration are significantly and dramatically increasing the amount of current that needs to be supplied to a module. Accordingly, the current topology employed is rapidly approaching a practical limit with respect to combining signal layers having fine line and vias with very heavy power planes in order to distribute the current to the module.

The present invention seeks to provide a package that exhibits high speed signals along with high current levels at relatively low voltage drop for the power supply.

The present invention provides a package capable of providing the high current levels necessary to power the logic and to reduce the package delays and skews in very large, high performance systems. The package of the present invention provides for separating the signal interconnection function from the power distribution function.

In particular, one aspect of the present invention is concerned with an integrated circuit chip package that comprises a substrate having a plurality of integrated circuit chips on at least one major surface thereof. Signal input/output connections for the integrated circuit chips are located at edges of the substrate. The conductive power planes are separated from the signal input/output connections and are removably connected to the substrate along one surface of the substrate to thereby carry power to the substrate.

Another aspect of the present invention is concerned with the use of two different substrates. This aspect of the present invention includes a first substrate having a plurality of integrated circuit chips on at least one major surface of the first substrate. A second substrate is electrically connected to the first substrate. Signal input/out connections for the integrated circuit chips are located at edges of the second substrate. Conductive power planes are separated from the signal input/output connections and are removably connected to the second substrate along one surface of the second substrate to carry power to the substrate.

As no power is carried by the input/output connections in the above package arrangements, the input/output connections such can be optimised for high speed signals consistent with the few milliamperes of signal current involved. This makes it possible to employ relatively small contact area, fine traces, and controlled impedances. With respect to the power planes, as no signal lines are involved, the vias in the power planes may be coarse to permit easy fabrication of relatively thick power plane boards, and the connector can be optimised for the purpose of carrying high currents at a relatively low voltage drop.

The scope of the invention is defined by the appended claims; and how it can be carried into effect is hereinafter particularly described with reference to the accompanying drawings, in which:-

Figure 1 is a schematic diagram in section of one embodiment of a package according to the present invention;

Figure 2 is a similar diagram of another embodiment of a package according to the present invention;

Figure 3 is a similar diagram of yet another embodiment of a package according to the present invention;

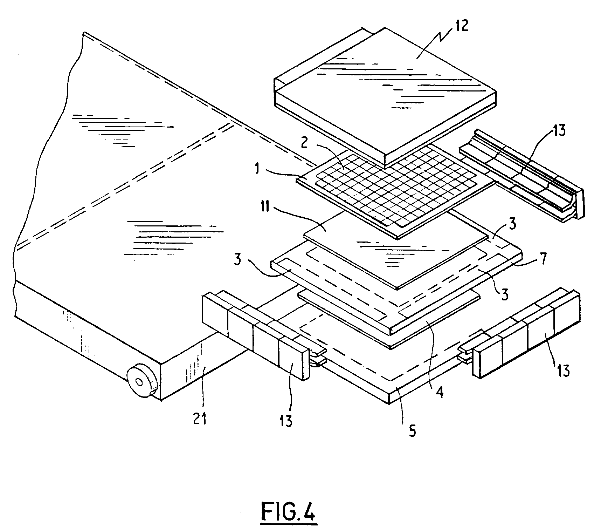

Figure 4 is an exploded view of the embodiment of Figure 3;

Figure 5 illustrates connection of a package according to the present invention to a power source;

Figure 6 illustrates the use of packages according to the present invention in a stacked arrangement;

Figure 7 is a view of the top surface of an edge-connected module forming part of another embodiment of package according to the invention;

Figure 8 is a bottom vie of the module of Figure 7;

Figure 9 is a cross-sectional view of the module of Figure 7;

Figure 10 is a cross-sectional view of part of another embodiment of package according to the invention;

Figure 11 is a plan view of a film assembly used in the module of Figure 10;

Figure 12 is a plan view of a film carrying a ground plane;

Figure 13 is a top view showing a typical layout of a memory module for a package according to the invention;

Figure 14 is a side view of the module of Figure 13;

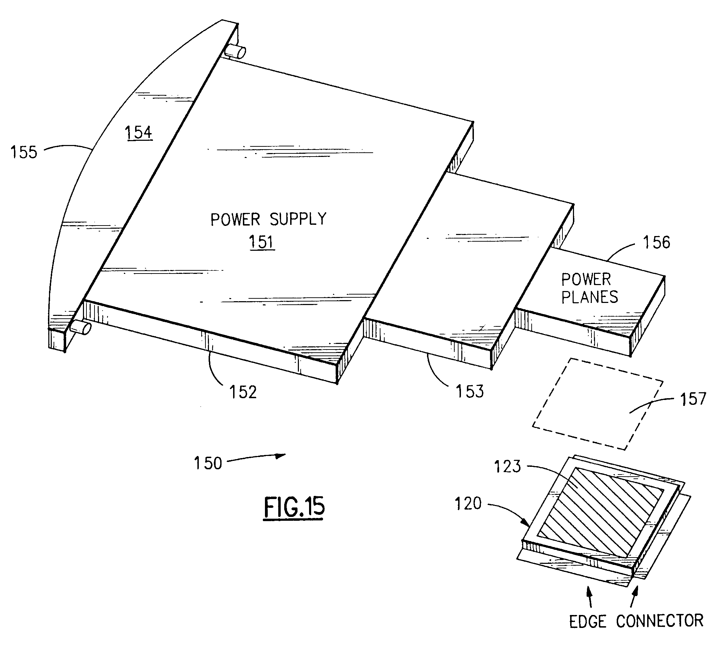

Figure 15 is a generalised isometric view showing how modules are connected to power supplies;

Figure 16 is a cross-sectional view of a connector between the power supply and module;

Figure 17 is an isometric view of stacked modules connected to signal boards; and

Figure 18 is a cross-sectional view of the connections in Figure 17.

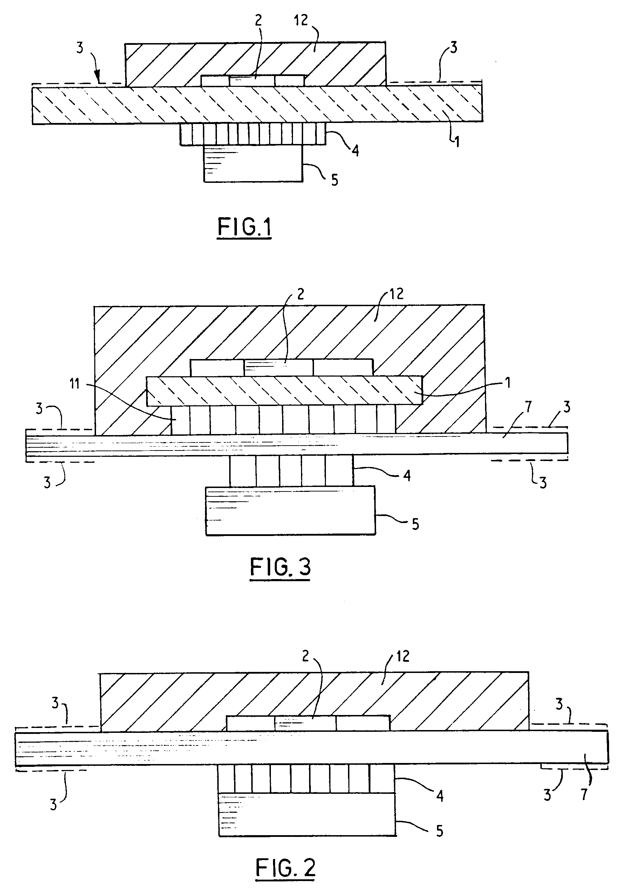

In an embodiment (Figure 1) of the present invention, a ceramic substrate 1 has a plurality of chips 2 on one of the surfaces thereof. The preferred ceramic substrates include silicon oxides and silicates such as aluminium silicate, and aluminium oxides. The chips can be connected to the substrate 1 by any well-known method such as by employing solder balls (not shown). Provided on two of the edges of the substrate 1 are signal input/output connection pads 3 of conductive metal such as gold or copper, and there are, for example, in the order of 4000 pads per edge at a one millimetre grid. Although, the signal input/output pads 3 are illustrated in Figure 1 as being on only one surface of two of the edges of substrate 1, if desired Signal input/output pads may be located on both major surfaces of substrate 1 and contact vias provided through the substrate 1.

Beneath ceramic substrate 1 on the other surface thereof is a power connector 4 and power planes 5. As the substrate is removably connected by the power connector 4 to the power planes 5, the substrate can be removed and replaced in the field, when necessary. The power connector 4 can be any known type of connector, and typically is a known area array power connector such as a pin/socket arrangement or an elastomeric interposer connector. Elastomeric interposer connectors include synthetic polymeric sheets such as rubber sheets having wires vertically embedded therein to transmit power. The ceramic substrate 1 includes contact vias or through holes so that power can be supplied from the power source via the power planes 5 and power connectors 4 vertically up underneath the chips 2 through the substrate 1. It is preferred that at least one of the edges of the substrate 1 is free of the signal input/output interconnectors so that the power planes may escape in the same general plane as the substrate. Located above the chips is a conventional heat sink or cooling plate arrangement 12. The power planes can be prepared by any of the known techniques in the prior art typical of which is the fabrication of printed circuit cards, but using heavier copper (e.g. 6.35 mm (1/4 inch)) a coarser grid (e.g. 2.54 mm (0.1 inch)) and large vias (e.g. 0.7620 mm (30 thousandths of an inch)).

Another embodiment (Figure 2) of a package according to the present invention, differs from that in Figure 1 in that the substrate is a printed circuit card 7 having vias therein up to the chips 2 in order that power can be provided vertically up underneath the chips 2 through the printed circuit card 7. Printed circuit cards and methods to provide such are well known in the art and need not be described here in any detail.

Another package (Figure 3) according to the invention, includes both a ceramic substrate 7 and a printed circuit card substrate 7. The substrate of the printed circuit card 7 contains the signal input/output connections 3 on the edges of both surfaces thereof. The ceramic substrate 1 and printed card substrate 7 are electrically connected to each other through a signal and power connector 11 such as a pin/socket or preferably an elastomeric interposer connector of the type discussed above. The signal and power connector could also be a permanent type connector such as solder balls or can be a separable and removable connector, if desired. The presence of the printed circuit card 7 makes it possible to increase the speed of the signals from the edges as compared to employing a ceramic substrate. On the other hand, compared to printed circuit boards, ceramics are more rigid and chips are more readily adherable to ceramics.

The power planes 5 are removably connected to the integrated printed circuit board substrate 7 through power plane connectors 4. As discussed above, such connectors can be any area array power connector such as pin/socket type connectors or elastomeric interposer connections.

By employing the particular package arrangement required by the present invention, the signal connections that are brought out to the edge or perimeter of the substrate on at least two opposite sides thereof and terminated in the signal input/output connection can be optimised for high speed signals consistent with the few milliamperes of signal current involved. This makes it possible to employ relatively small contact area, fine traces and controlled impedances.

In addition, the vias in the power planes can be relatively coarse which facilitates fabrication of the relatively thick power plane board, and the connector can be optimised for carrying higher currents at a low voltage drop.

The embodiment of Figure 3 includes a conventional heat sink or cooling plate arrangement 12 located above the chips 2.

The integrated printed circuit card 7 having signal connections 3 on three edges thereof is connected to the ceramic substrate 1 via the area array power and signal connector 11. Power for the signal connections is provided the flexible signal connectors 13 that mate with the signal input/output connectors 3 on the edges of the printed circuit card 7. Power is provided from a power source 21 to the power planes 5 to the area array power connector 4.

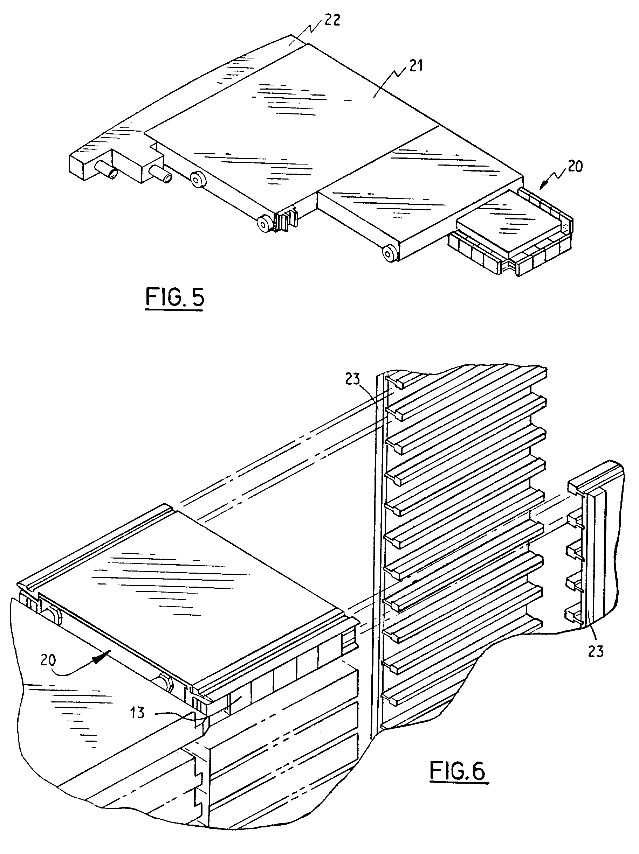

The assembled module 20 (Figure 5) is connected to power source 21 which in turn is maintained at desired temperature employing a water cooling device 22.

The assembled modules 20 (Figure 6) can be placed between two signal boards 23 in a slidable manner so that the boards connect through the signal connectors 13 shown.

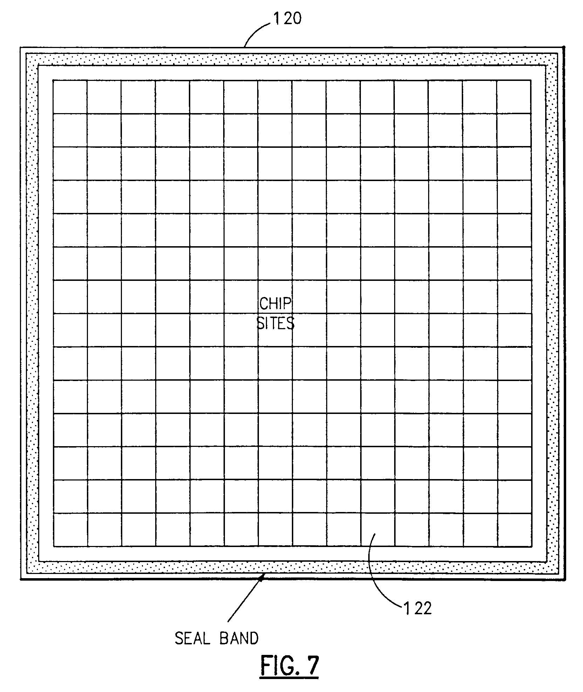

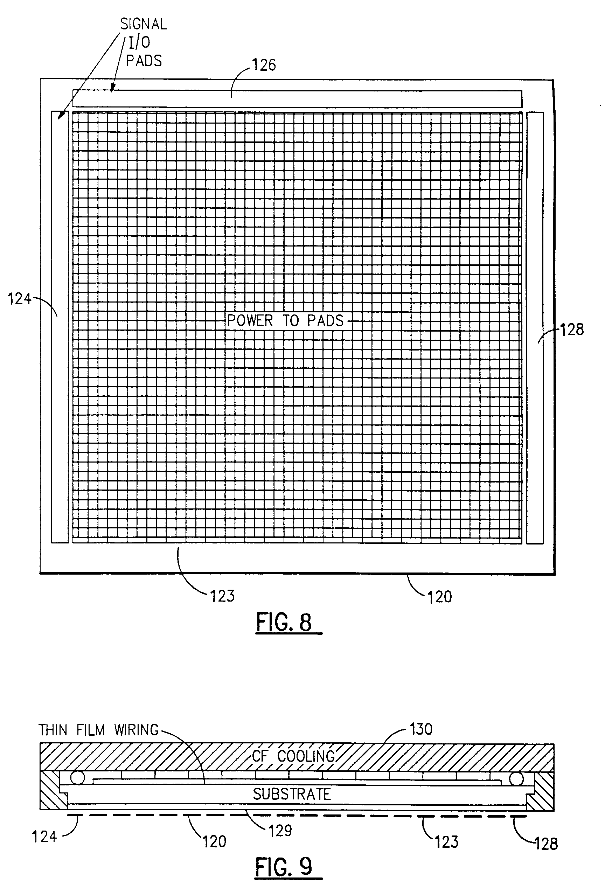

Another embodiment of the invention is in the form of an edge connected module (ECM) 120 (Figure 7), the top surface of which is illustrated. One hundred and ninety six chip sites 122 are shown where logic and/or array chips may be mounted. The bottom surface of the ECM 120 (Figure 8), is where the area underneath the chip sites is dedicated to power pads 123 which make connections to the power supply for the ECM. Three of the four perimeter edges on the bottom surface carry dense arrays of signal input/output (I/O) pads 124, 126 and 128. I/O pads 124 and 128 on opposing edges of the ECM facilitate connections within a subsystem, while I/O pads 26 facilitate global connections. The chips-to-substrate interface is such that mismatches in thermal expansion coefficients do not cause undesirable stress on the bond, either by the cushioning effect (compliance) of thin film wiring (Figure 9) used on the top surface to escape from the chip I/Os and to provide local interconnections or by matching the thermal coefficient of expansion of the substrate to that of the chip. Glass ceramic, copper/invar/copper or printed circuit boards would be suitable substrate materials.

For long wires on the module, where propagation velocity and low electrical resistance are desired, one or more layers of fatter wiring 129 are on the bottom surface, where they can interconnect the chip signal I/Os with the I/O pads 124, 126 and 128 around the perimeter of the module. Vias connect gold-plated power pads on the bottom surface of the substrate to the chip power I/Os, and others permit signal connections to pass from the top to the bottom surface. Although the signal connections are shown only on the bottom surface, both surfaces may be used if a connector such as that disclosed in US -A- 4,636,019 is used. A cooling manifold 130 is in contact with the chips mounted on the ECM 120. Cooling of the chips may be accomplished by any of a number of ways known in the art. The preferred form of cooling is a liquid coolant circulating in a cooling jacket in thermal contact with the integrated circuit chips on the ECM, but other forms of cooling, including air convection or radiation, may be used depending on the thermal requirements of the computer system.

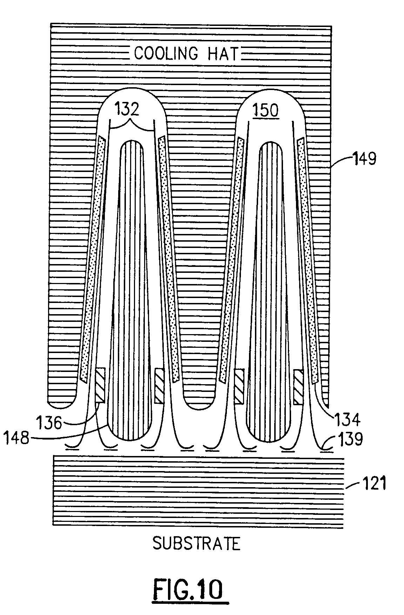

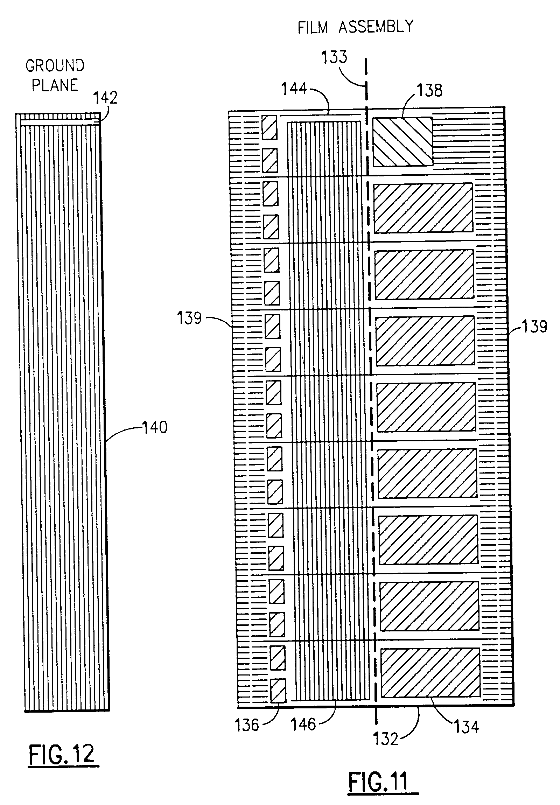

A package according to the invention may be in the form of a memory edge-connected module (Figure 10) which is required to contain many more chips than the processor ECM to maintain acceptable volumetric density. Figure 3a shows a flexible film 132 (Figure 11) has wiring on two surfaces on which are mounted memory array chips 134, their decoupling capacitors 136 and a terminating resistor chip 138. The film 132 is folded along the centre line 133 of its long axis and mounted to a substrate 121 (Figure 10) with outer lead bonds 139 along the two long edges (Figure 11). A film 140 (Figure 12) carries a ground plane film 140 connected at one end 142 to edge 144 (Figure 11) of the film 132 and provides a return path for long address and control wires 146 which originate and terminate at the end to which the ground plane is attached.

A compliant member 148 (Figure 10) which may be a spring or strip of elastomer, is placed between two rows of back-to-back films 132. A cooling hat 149 having cavities 150 is placed over this assembly so that the memory array chips 134 on the films 132 are pressed against the inside surfaces of the cavities 150 receiving the back-to-back films to provide good thermal conductivity. A thin layer of thermally conductive oil further enhances this interface.

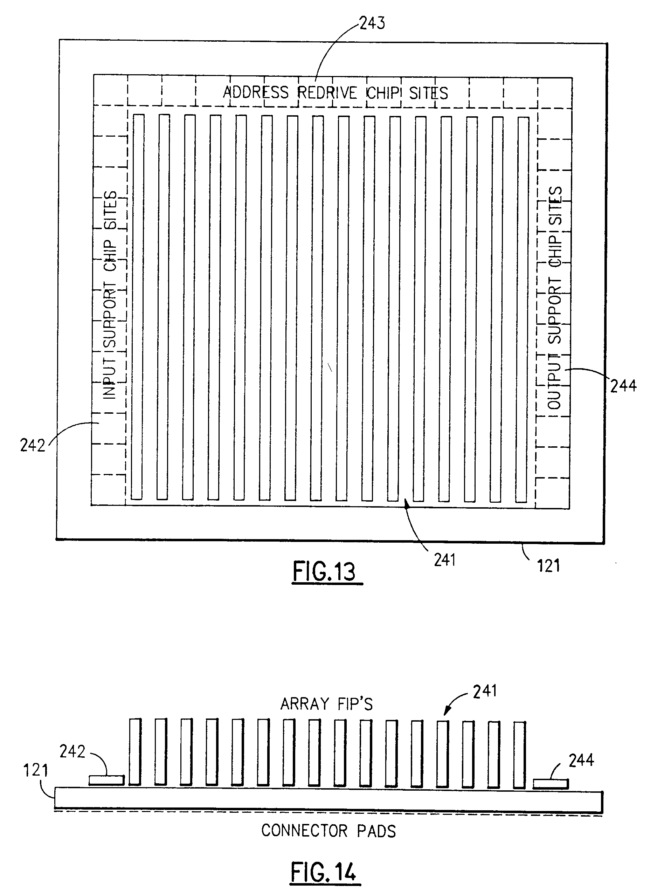

In a typical layout (Figure 13) of a memory ECM employing this construction, the film strips 132 fill the centre of the top surface of a module in an array 241, and logic support chips are located around the same three sides of the perimeter carrying the signal I/O pads on the lower surface of the module. The logic support chips include input support chips 242, address redrive chips 243 and output support chips 244. Note that the data input and the data output support chips are at opposite edges of the module, in such a way that address, input data and control signals enter at one edge and output data leaves from the opposite edge.

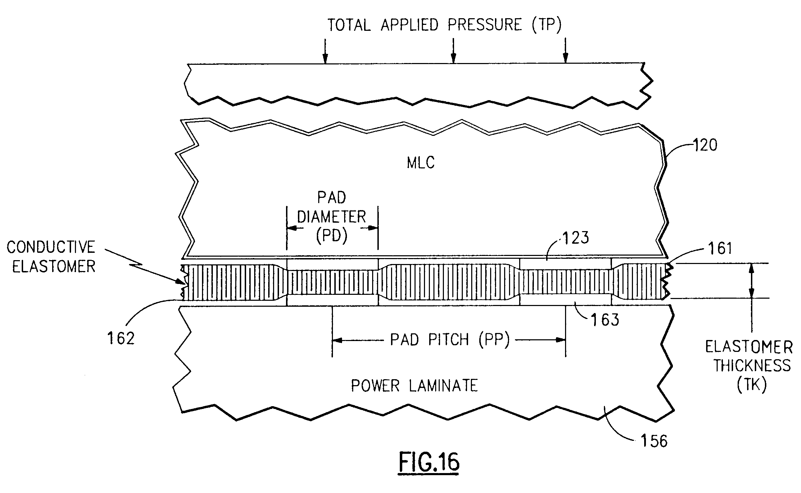

Each ECM comprises a power boundary and so has its own dedicated power supply. The module and its power supply 151 are assembled together to form a field replaceable unit (FRU) 150 (Figure 5). The power supply 151 comprises a primary section 152, a secondary section 153 and a water cooling manifold 154, the latter having a generally arcuate outer edge 155 conforming to the outer surface of a computer system. The interface between the module and its power supply 151 is via power planes 156 and power connecter 157. The power planes section 156 is an extension of the secondary section 153. Power pads (not shown) on the under surface of the power planes 156 correspond with power pads 123 on the mating surface of the module. Connection between the power plane 156 and the module is accomplished by use of an interposer connector 157, such as Shin-Etsu's Polymer MAF, Fujipoly's W series, TRW's "Fuss-Button" or similar connectors by AMP Inc., Rogers Corp., AT&T and others. An example of this type of connecter 157 (Figure 16) comprises a flat sheet of elastomer 161 embedded with metal fibres 162 to maintain paths of conductivity through the thickness of the elastomer. There is, however, no conductivity along either of the other dimensions of the elastomer. Thus, when power pads 163 of the power planes 156 are brought into registry with the power pads 123 of the module, a good electrical connection is made between the two pads of each set, but not between the pads of different sets.

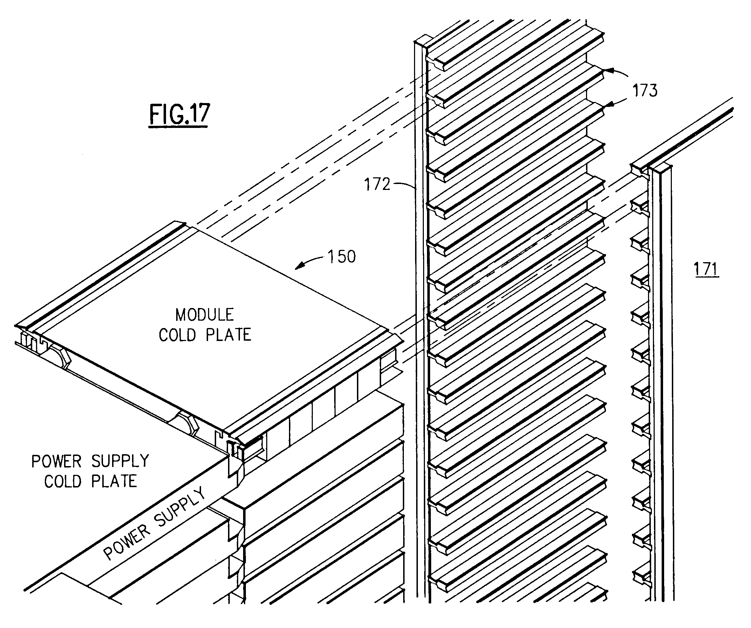

For the next level of packaging, the field replaceable units of are stacked like trays above each other (Figure 17). Their signal interconnections are made with zero insertion force (ZIF) connectors, such as described in US -A- 4,636,019. Figure 7 shows how each FRU 150 (Figure 17) is inserted between two wiring boards 171 and 172 along connector guides 173, so that, when seated, the ZIF connectors make the electrical connection between the module and the boards. The third (front) board and its associated connector are omitted in this illustration to show an embodiment for an application where the front board is not required.

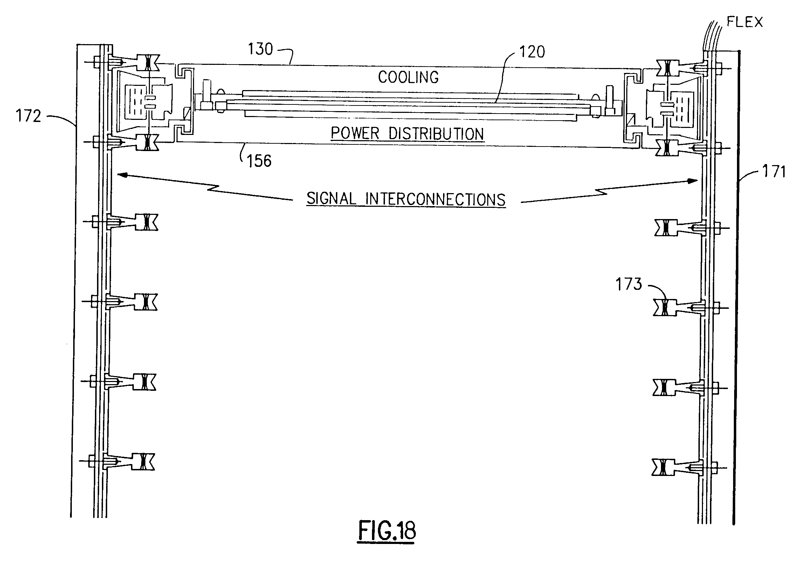

Power distribution and signal interconnections (Figure 18) are separated, freeing the vertical signal interconnecting boards to be dedicated to signal wiring without the need to incorporate heavy power distribution planes.

The invention provides an arrangement whereby the signal wiring and power distribution are separate from each other. In addition, the integrated circuit chip package of the present invention makes it possible to remove the module from the power plane and replace it in the field.

## Claims

1. An integrated circuit chip package comprising a substrate (1;7) having a plurality of integrated chips (2) on at least one major surface thereof, signal input/output connections (3) for the chips (2) located at edges of the substrates and conductive power planes (5) separated from the signal input/output connections (3) and removably connected to the substrate (1;7) along one surface of the substrate, thereby to carry power to the substrate.

2. A package according to claim 1, wherein the substrate (1) is of ceramic.

3. A package according to claim 1, wherein the substrate is a printed circuit card (7).

4. A package according to claim 1, 2 or 3, wherein the input/output connections (3) are located on three edges of the substrate (1;7).

5. A package according to claim 1, 2, 3 or 4, wherein the input/output connections (3) are located on both surfaces of the substrate (1;7).

6. A package according to any preceding claim, wherein the power planes (5) are connected to the substrate by an area array power connector (4).

7. An integrated circuit chip package comprising a first substrate (1) having a plurality of integrated chips (2) on at least one major surface thereof, a second substrate (7) electrically connected to the first substrate and having signal input/output connections (3) for the the integrated chips located at edges of the second substrate (7), conductive power planes (5) separated from the signal input/output connections (3) and removably connected to the second substrate (7) along one surface of the second substrate thereby to carry power to the first substrate (1).

8. A package according to claim 7, wherein the first substrate (1) is of ceramic.

9. A package according to claim 7 or 8, wherein the second substrate (7) is a printed circuit card.

10. A package according to claim 7, 8 or 9, wherein the input/output connections (3) are located on three edges of the second substrate (7).

11. A package according to claim 7, 8, 9 or 10, wherein the input/output connections (3) are located on both surfaces of the second substrate (7).

12. A package according to claim 7, 8, 9, 10 or 11, wherein the power planes (5) are connected to the second substrate by an area array power connector(4).

FIG.1

FIG. 3

FIG. 2

6

**FIG.4**

FIG. 5

FIG.6

FIG. 7

SIGNAL
I/O
PADS

126

124

POWER TO PADS

128

123

120

FIG. 8

THIN FILM WIRING

130

CF COOLING

SUBSTRATE

124

120

129

123

128

FIG. 9

COOLING HAT

132     150

149

136    134

148    139

121

SUBSTRATE

FIG.10

GROUND
PLANE

FILM ASSEMBLY

FIG.12

FIG.11

FIG.13

ARRAY FIP'S

CONNECTOR PADS

FIG.14

POWER SUPPLY
151

POWER PLANES

EDGE CONNECTOR

FIG.15

EP 0 506 225 A2

TOTAL APPLIED PRESSURE (TP)

MLC

120

PAD
DIAMETER
(PD)

CONDUCTIVE
ELASTOMER

123

161

162

163

PAD PITCH (PP)

POWER LAMINATE

ELASTOMER
THICKNESS
(TK)

156

FIG.16

EP 0 506 225 A2

FIG.17

FIG.18

EP 0 506 225 A2